Europäisches Patentamt

European Patent Office

Office européen des brevets

(19)

(11) Veröffentlichungsnummer: **0 382 032**
**A2**

# (12) EUROPÄISCHE PATENTANMELDUNG

(21) Anmeldenummer: **90101678.2**

(22) Anmeldetag: **28.01.90**

(51) Int. Cl.5: **G03F 7/42**

(30) Priorität: **09.02.89 DE 3903736**

(43) Veröffentlichungstag der Anmeldung:
**16.08.90 Patentblatt 90/33**

(84) Benannte Vertragsstaaten:
**CH DE FR GB IT LI NL SE**

(71) Anmelder: **BAYER AG**

**D-5090 Leverkusen 1 Bayerwerk(DE)**

(72) Erfinder: **Horbach, Alfred, Dr.**
**Am Heckerhof 48**
**D-4150 Krefeld(DE)**
Erfinder: **Kämpf, Günther, Prof.Dr.**
**Wöhlerstrasse 4**
**D-4150 Krefeld(DE)**
Erfinder: **Eiling, Aloys, Dr.**
**Schmiedestrasse 12**
**D-4630 Bochum 6(DE)**
Erfinder: **Pott, Richard-Anton, Dr.**
**Im Rosengarten 4**
**D-5090 Leverkusen 3(DE)**

(54) **Mikrostrukturierung von Polymer-Metallverbundschichten.**

(57) Bei dem verfahren zur Mikrostrukturierung wird eine als Substrat verwendete Polymer-Metall- oder Polymer-Halbleiter-verbundschicht als Substrat verwendet.Dieses Substrat wird durch eine der vorgegebenen Mikrostrukturierung entsprechende Maske hindurch belichtet, anschließend die belichteten Bereiche der Photoresist-Schicht abgeätzt und nach einer weiteren physikalischen und/oder chemischen Behandlung der offenliegenden Substratbereiche die verbliebenen Photoresist-Bereiche mit Hilfe eines Lösungsmittels entfernt. Bewährt haben sich dabei Lösungsmittel aus der Gruppe der längerkettigen aliphatischen Ether/Ketone, Ester mit C > 2, Alkohole mit C > 4 oder der cyclo-aliphatischen Ether.

EP 0 382 032 A2

FIG.2

## Mikrostrukturierung von Polymer-Metallverbundschichten

Die Erfindung fußt auf der bekannten Technik der Mikrostrukturierung, wie sie insbesondere in der Mikroelektronik zur Herstellung integrierter Schaltungen auf Si-Wafern eingesetzt wird. Der derzeitige technische Stand der Mikrostrukturierung sieht so aus, daß ein photoempfindlicher Lack (Resist) auf einem Wafer in dünner Schicht aufgetragen und dann durch eine Maske belichtet wird. In den Bereichen der Belichtung tritt eine chemische Änderung auf, die dazu führt, daß die belichteten Bereiche von einem speziellen Lösemittel nunmehr gelöst (Positiv-Resist) werden. Nach dem Weglösen dieses Resistanteils liegen Mikrostrukturen auf der Waferoberfläche offen, die nun durch chemische oder physikalische Verfahren (wie Dotieren, Bedampfen, Abtragen oder Oxidieren) gegenüber den noch bedeckten Flächen verändert werden können.

Die Kombination von Photolacken, die in der Regel auf Basis Novolacke aufgebaut sind, mit selektiven Löse mitteln ist im Bereich der Mikrostrukturierung anorganischer Substratmaterialien, wie sie in der Halbleitertechnik Anwendung finden, Stand der Technik.

Der Erfindung liegt die Aufgabe zugrunde, die bekannten Verfahren zur Mikrostrukturierung auf der Basis der Photoresist-Technik zu modifizieren bzw. weiter zu entwickeln, um Mikrostrukturen in Polymersubstraten herzustellen. Insbesondere sollen dabei Polymerfilme zugrunde gelegt werden, die aus einem Copolymer der Monomerkomponenten Vinylfluorid und Trifluorethylen bestehen, wobei der Polymerfilm in dünner Schicht auf eine anorganische Unterlage aufgezogen ist.

Aus der Halbleitertechnik bekannte Verfahren sind nicht einfach übertragbar, da beim Ablösen des Restresists bei Anwendung der gebräuchlichen Lösemittel (z.B. Aceton) ebenfalls der Polymerfilm, der in diesem Fall Bestandteil der fertigen Gesamtstruktur ist, angegriffen wird.

Diese Aufgabe wird bei einem mit Hilfe der Photoresist-Technik behandelten Substrat erfindungsgemäß dadurch gelöst, daß als Substrat eine Polymer-Metallverbundschicht verwendet wird und die zuletzt verbliebenen Photoresist-Bereiche durch ein Lösungsmittel aus der Gruppe der längerkettigen aliphatischen Ether/Ketone, Ester mit C > 2, Alkohole mit C > 4 oder der cycloaliphatischen Ether entfernt werden. Es wurde gefunden, daß Lösungsmittel dieser Art selektiv den Photoresist lösen, ohne den Polymerfilm zu schädigen.

Als Polymer wird vorzugsweise ein P-(VDF/TrFE)-Copolymer mit weniger als 50 % TrFE, vorzugsweise weniger als 30 % TrFE, verwendet.

Eine Weiterentwicklung ist dadurch gekennzeichnet, daß die Polymer-Metallverbundschicht vor der Mikrostrukturierung auf einen Halbleiter-Wafer aufgebracht wird. Auf diese Weise lassen sich vorteilhaft integrierte Schaltkreise auf Halbleiterbasis in Kombination mit ferroelektrischen Polymerschichten als Speicherbausteine herstellen. Ein solcher Baustein wird in EP-A-236 696 näher beschrieben.

Im folgenden wird anhand einer Zeichnung und eines Ausführungsbeispiels die Erfindung näher erläutert.

Es zeigen

Fig. 1 einen Querschnitt durch eine Testanordnung, bestehend aus einer mit einem Photoresist beschichteten, auf einem Halbleiter-Wafer aufgebrachten Polymer-Metallverbundschicht;

Fig. 2 die strukturierte Polymer-Metallverbundschicht nach dem Abätzen der belichteten Photoresist-Bereiche und nach dem Ablösen der zuletzt auf den Metalloberflächen verbliebenen Photoresist-Schichten und

Fig. 3 eine Draufsicht auf die mikrostrukturierte Polymer-Metallverbundschicht nach Fig. 2.

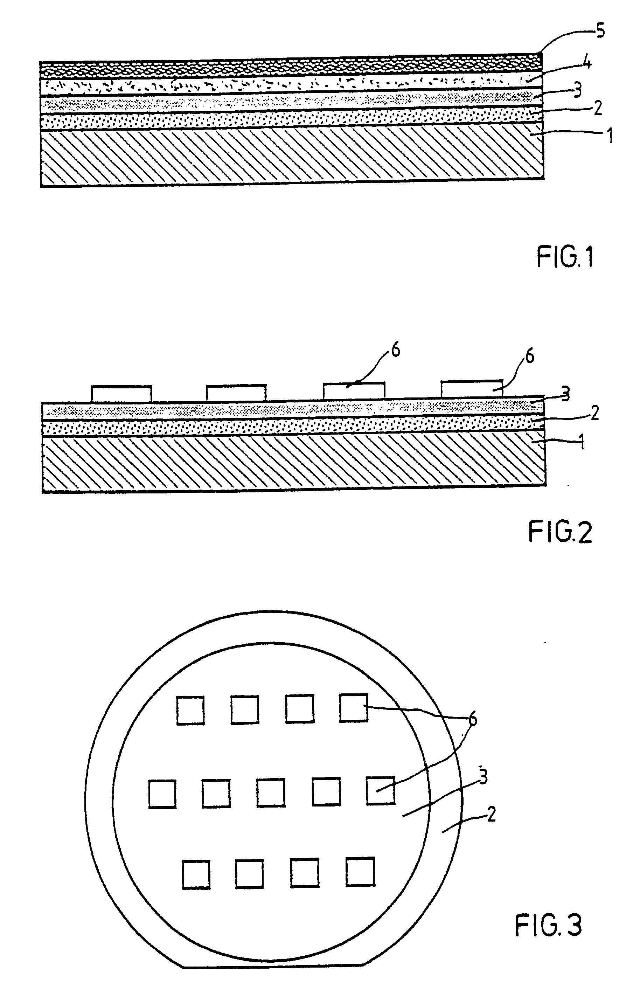

Die Polymer-Metall-Halbleiterverbundstruktur gemäß Fig. 1 besteht aus einem Si-Wafer 1, auf den eine Aluminiumschicht 2 aufgedampft wurde. Auf die Aluminiumschicht 2 wurde eine 0,1 $\mu$m dicke Schicht 3 von P(VDF/TrFE) durch Spincoaten aufgebracht. Auf diese Struktur wurde sodann eine weitere Aluminiumlage 4 aufgedampft, die mittels Spincoaten mit einem Photolack (Photoresist) 5 beschichtet wurde.

Durch eine der gewünschten Mikrostrukturierung entsprechende Lochmaske wurde sodann die Photolackschicht 5 belichtet. Anschließend wurden die belichteten Photolackbereiche selektiv abgelöst. Die nunmehr freiliegenden Aluminiumfelder wurden danach abgetragen, so daß die oberste Schicht nunmehr aus einer Vielzahl getrennter Aluminiumfelder 6 (siehe Fig. 2) besteht, die noch mit dem unbelichteten Photolack abgedeckt sind. Die noch verbliebenen Photoresist-Bereiche werden dann im letzten Schritt des Verfahrens durch ein spezielles Lösungsmittel entfernt, wobei die Polymerschicht 3 nicht verändert (angegriffen) werden darf. Als fertige Polymer-Metall-Halbleitermikrostruktur ergab sich die in Fig. 2 dargestellte planare Kondensatorzellenanordnung mit den oberen Kondensatorflächen 6, dem ferroelektrischen Dielektrikum 3 und der unteren gemeinsamen Kondensatorelektrode 2 auf dem Si-Wafer 1.

Ausführungsbeispiele

Beispiel 1

Ein P(VDF/TrFE)-Copolymer der Zusammensetzungen 75/25 (75 % VDF und 25 % TrFE) wird in DMF (Dimethylformamid) zu einem Volumenprozentanteil von 5 % gelöst. Diese Lösung wird mit einem Spincoater (Convac 100) auf einem Aluminium bedampften 2 Si-Wafer 1 abgeschleudert. Der beschichtete Wafer 1, 2, 3 wird typisch 60 Minuten zwischen 40 und 260°C in einem Trockenschrank getempert. Nach dem Trocknen und Tempern wird auf den so vorbereiteten Wafer eine weitere Aluminiumschicht 4 aufgedampft. Auf diese Metallschicht wird dann mit dem gleichen Spincoater ein handelsüblicher Diazonaphthoquinon-Novolack, JSR PFR 3003A als Photoresist-Schicht 5 mit dem gleichen Spincoater abgeschleudert. Diese Photoresist-Schicht 5 wird in einem anschließenden Schritt durch eine Lochmaske mit kreisförmigen Löchern mit einem Durchmesser von 0,5 cm belichtet. Danach wurden die belichteten Bereiche mit einem für diesen Photoresist-Typ handelsüblichen Lösungsmittel, z.B. Microstrip 2000, Olin, abgeätzt.

Die freigelegten Aluminium-Bereiche wurden anschließend naßchemisch mit einer Mischung aus $H_3PO_4$, $CH_3COOH$, $HNO_3$, $H_2O$ und $NH_4F$ abgetragen. Dieses Verfahren ist Stand der Technik (z.B. I. Ruge in Halbleiter-Technologie, Berlin, Springer Verlag 1984) und wird derzeit angewandt für die Herstellung von integrierten Schaltkreisen.

Nach diesem Schritt wird der Wafer in ein 80°C warmes Ultraschallbad aus THF (Tetrahydrofuran) gelegt, wodurch der restliche Resist, der zuvor unbelichtet geblieben war, auf den stehengebliebenen Aluminium-Feldern 6 abgelöst wird.

Die anschließenden Messungen der elektrischen und ferroelektrischen Eigenschaften ergeben, daß die Polymer-Schicht 3 hinsichtlich ihrer chemischen und physikalischen Eigenschaften bei diesem Prozeß nicht verändert wird.

Beispiel 2

Wie Beispiel 1. Anstelle von THF werden jedoch andere cyclische aliphatische Ether, z.B. Dioxan, eingesetzt.

Beispiel 3

Wie Beispiel 1. Statt THF werden jedoch aliphatische Ketone mit ≥ 3 und ≤ 10 C-Atomen pro Molekül eingesetzt (z.B. Methylethylketon und Diethylketon).

Beispiel 4

Wie Beispiel 1. Bei einem VDF-Anteil ≥ 60 % werden aber statt THF aliphatische Ester mit ≧ 6 C-Atomen pro Molekül, z.B. Butylacetat, eingesetzt.

Beispiel 5

Wie Beispiel 4. Als Lösungsmittel werden jedoch statt aliphatischen Estern aliphatische Glykole, z.B. Ethylglykol oder Butylglykole, eingesetzt.

Beispiel 6

Wie Beispiel 4. Als Lösungsmittel werden aber statt aliphatischen Estern aliphatische Monoalkohole mit > 1 C-Atom und < 6 C-Atome pro Molekül, z.B. Ethanol, Isopropanol, Butanole, eingesetzt.

**Ansprüche**

1. Verfahren zur Mikrostrukturierung flächenförmiger Substrate mit Hilfe der Photoresist-Technik, bei dem das Substrat mit einem Photoresist beschichtet wird, durch eine der vorgegebenen Mikrostrukturierung entsprechende Maske belichtet wird, anschließend die belichteten Bereiche der Photoresist-Schicht abgeätzt werden und nach einer weiteren physikalischen und/oder chemischen Behandlung der offenliegenden Substratbereiche die verbliebenen Photoresist-Bereiche durch ein Lösungsmittel entfernt werden, dadurch gekennzeichnet, daß als Substrat eine Polymer-Metall- oder Halbleiterverbundschicht verwendet wird und die zuletzt verbliebenen Photoresist-Bereiche durch ein Lösungsmittel aus der Gruppe der längerkettigen aliphatischen Ether/Ketone, Ester mit C > 2, Alkohole mit C > 4 oder der cyclo-aliphatischen Ether entfernt werden.

2. Verfahren nach Anspruch 1, dadurch gekennzeichnet, daß als Polymer ein P(VDF/TrFE)-Copolymer mit weniger als 50 % TrFE, vorzugsweise weniger als 30 % TrFE verwendet wird.

3. Verfahren nach Anspruch 1 bis 2, dadurch gekennzeichnet, daß die Polymer-Metall- oder Halbleiterverbundschicht vor der Mikrostrukturierung auf einem Halbleiter-Wafer aufgebracht wird.

FIG.1

FIG.2

FIG.3